# FASCICULE DE BREVET EUROPEEN

(11) **EP 2 278 614 B1**
(45) Date de publication et mention de la délivrance du brevet: **03.04.2013**
(21) Numéro de dépôt: 10166937.2
(22) Date de dépôt: 22.06.2010
(51) Int. Cl.: H01L 21/768, H01L 23/48, H01L 25/065

(54) **Via de connexion électrique comportant des excroissances latérales**
Durchkontaktierung mit seitlichen Erweiterungen
Electrical via with lateral extensions

(30) Priorité: 21.07.2009 FR 0955056
(43) Date de publication de la demande: 26.01.2011
(73) Titulaire: STMicroelectronics (Crolles 2) SAS, 38920 Crolles (FR)
(72) Inventeur: Chaabouni, Hamed, 38000 Grenoble (FR); Cadix, Lionel, 38000 Grenoble (FR)
(74) Mandataire: de Beaumont, Michel

(56) Documents cités:
- WO-A1-99/25026
- WO-A1-2009/005462
- WO-A1-2009/051239
- JP-A- 5 235 544
- US-A- 5 160 987
- US-A1- 2004 061 238
- US-A1- 2007 023 913
- US-A1- 2007 184 654

## Description

### Domaine de l'invention

La présente invention concerne une connexion électrique isolée entre la face avant et la face arrière d'un substrat, couramment désignée dans la technique par le terme via.

### Exposé de l'art antérieur

Parmi les nombreux domaines d'utilisation des vias, on peut citer les dispositifs à empilement de puces. Dans ces dispositifs, on prévoit de superposer des puces ou des tranches semiconductrices, accolées les unes aux autres. Ceci permet d'augmenter les fonctions réalisées par un dispositif sans augmenter la surface occupée.

Dans ces dispositifs, les connexions entre les composants des différents étages peuvent être réalisées soit par des techniques traditionnelles de câblage filaire, soit par des vias traversant le substrat des puces.

Un avantage des vias réside dans la possibilité de les fabriquer collectivement, contrairement aux fils pour lesquels un montage unitaire doit être réalisé. Les autres principaux avantages des vias par rapport aux fils résident dans le gain de surface qu'ils apportent, l'amélioration des performances électriques, et la possibilité de répartition en surface des entrées/sorties. Un autre avantage de la connexion par vias est que ces vias seront couramment réalisés dans des tranches de silicium. Ces tranches de silicium seront ensuite assemblées de diverses manières dont celle décrite ci-après, puis pourront être découpées en puces individuelles. De tels procédés collectifs conduisent à des réductions de coût. Dans la présente description, on mentionnera des assemblages de puces, mais il sera clair que ces puces pourront être des plaques, des tranches semiconductrices ou des éléments de tranches semiconductrices.

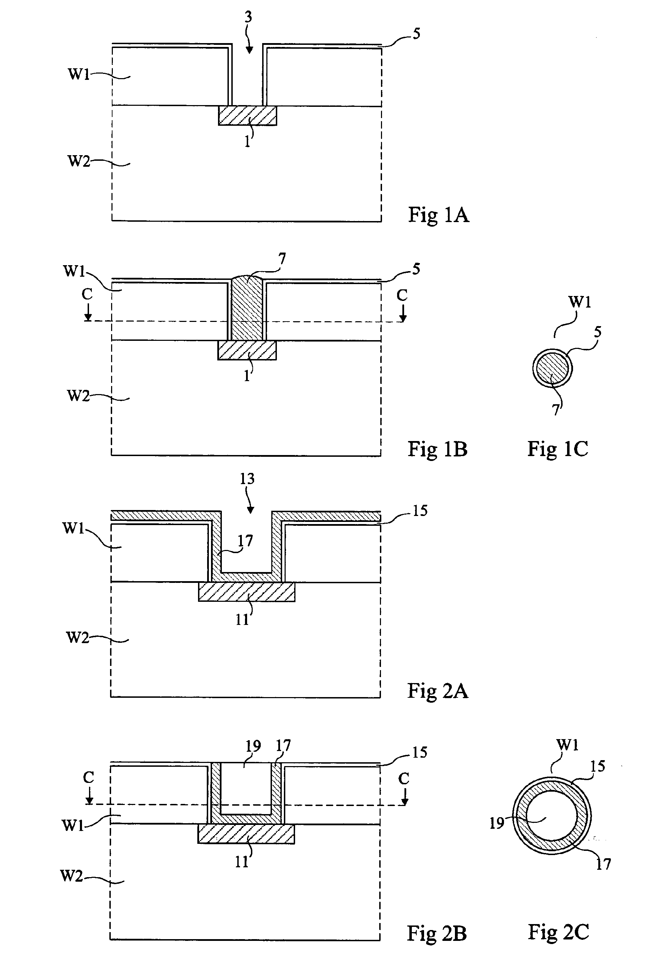

Les figures 1A et 1B sont des vues de côté en coupe illustrant des étapes d'un procédé de réalisation d'un via plein de diamètre inférieur à 10 µm, par exemple de l'ordre de 0,5 à 10 µm. La figure 1C est une vue de dessus en coupe selon le plan C-C de la figure 1B, et représente une section du via réalisé.

Une puce ou tranche semiconductrice amincie W1 est superposée à une puce ou tranche semiconductrice W2. Les puces W1 et W2 sont par exemple collées entre elles par adhérence moléculaire. L'amincissement de la puce W1 peut être réalisé avant ou après le collage. Les puces W1 et W2 sont chacune formées dans un substrat semiconducteur, selon des procédés de réalisation classiques. Elles comportent notamment chacune des zones actives, dans lesquelles sont formés des composants, et un empilement de pistes conductrices d'interconnexion, par exemple des pistes de cuivre, reliant les composants entre eux et aux entrées/sorties. A la surface de la puce W2, du côté de la face commune aux puces W1 et W2, il est prévu un plot de contact conducteur 1, correspondant par exemple à une portion de cuivre d'un niveau d'interconnexion supérieur. Le plot de contact 1 est relié à une borne de la puce par des pistes conductrices non représentées de façon à pouvoir être connecté à un potentiel de référence lors d'une étape ultérieure de dépôt électrolytique.

Un trou 3, traversant de part en part le substrat de la puce W1, est formé en regard du plot de contact 1. Le trou 3 peut être percé par gravure sèche ou gravure chimique. Une isolation des parois du trou 3 est réalisée, par exemple par dépôt d'une couche 5 d'oxyde de silicium. La portion de la couche isolante 5 recouvrant, au fond du trou 3, le plot de contact 1, est retirée pour laisser le plot 1 accessible.

L'assemblage ainsi réalisé est plongé dans une solution électrolytique conductrice adaptée, par exemple de sulfate de cuivre. Le plot de contact 1 est mis à un potentiel négatif et forme une cathode. Une anode de cuivre, reliée à un potentiel positif, est plongée dans la solution électrolytique. Il circule alors un courant entre l'anode et la cathode. Du cuivre se dépose progressivement par électrolyse sur la cathode, venant remplir le trou 3. L'électrolyse est interrompue lorsque le trou 3 est plein, formant ainsi un via conducteur cylindrique 7. On peut en outre prévoir une étape de planarisation, pour égaliser la surface du via 7 après l'électrolyse.

Pour des diamètres supérieurs à quelques µm, le remplissage par électrolyse serait trop long et trop coûteux à mettre en oeuvre.

Les figures 2A et 2B sont des vues de côté en coupe illustrant des étapes de réalisation d'un via creux de diamètre supérieur à 10 µm, par exemple de l'ordre de 10 à 200 µm. La figure 2C est une vue de dessus en coupe selon le plan C-C de la figure 2B, et représente une section du via réalisé.

Des puces ou tranches semiconductrices W1 et W2 sont superposées de la façon décrite ci-dessus. A la surface de la puce W2, du côté de la face commune aux puces W1 et W2, il est prévu un plot de contact conducteur 11, correspondant par exemple à une portion de cuivre d'un niveau d'interconnexion supérieur.

Un trou 13 traversant de part en part la puce W1, est percé en regard du plot 11. Une gaine d'isolation des parois du trou 13 est formée, par exemple par dépôt d'une couche 15 d'oxyde de silicium. La portion de la couche isolante 15 recouvrant le plot de contact 11 est retirée pour laisser le plot 11 accessible.

Une couche conductrice 17, par exemple une couche de cuivre, est formée par dépôt conforme sur les parois isolées et sur le fond du trou 13. La couche 17 forme un contact avec le plot 11 de la puce W2.

Les portions de la couche 17 à la surface de la puce W1 sont retirées pour ne conserver que la partie appliquée sur les parois isolées et sur le fond du trou 13. La partie restante de la couche 17 forme ainsi un via tubulaire 17, ayant en vue de dessus la forme d'un anneau.

Le via 17 est généralement comblé par une résine de remplissage 19.

En fonctionnement, lorsque les vias sont parcourus par des courants, ils produisent par effet Joule de la chaleur. Il en résulte une élévation de leur température, pouvant conduire à des dégradations ou à une réduction de la durée de vie des puces.

Les documents US20040061238 et US20070184654 décrivent d'autres exemples de vias connus.

### Résumé

Un objet d'un mode de réalisation de la présente invention est de pallier tout ou partie des inconvénients des vias classiques.

Un objet d'un mode de réalisation de la présente invention est de proposer une structure de via permettant de limiter l'élévation de la température du via lorsqu'il est parcouru par un courant.

Ainsi, un mode de réalisation de la présente invention prévoit un via de connexion électrique selon la revendication 1.

De plus, un mode de réalisation de la présente invention prévoit un procédé de fabrication d'un via de connexion électrique selon la revendication 3.

Des modes de réalisation privilégiée de la présente invention sont décrits dans les revendications dépendantes.

### Brève description des dessins

Les figures 1A et 1B, précédemment décrites, sont des vues de côté en coupe illustrant des étapes de réalisation d'un via plein de diamètre inférieur à 10 µm ;
la figure 1C, précédemment décrite, est une vue de dessus en coupe de la figure 1B représentant une section d'un via plein ;
les figures 2A et 2B, précédemment décrites, sont des vues de côté en coupe illustrant des étapes de réalisation d'un via tubulaire de diamètre supérieur à 10 µm ;
la figure 2C, précédemment décrite est une vue de dessus en coupe de la figure 2B représentant une section d'un via tubulaire ;
la figure 3 est une vue de côté en coupe représentant de façon très schématique un mode de réalisation d'un via plein de diamètre inférieur à 10 µm ;
les figures 4A à 4H illustrent des étapes successives d'un exemple de procédé de réalisation du via de la figure 3 ;
la figure 5 est une vue schématique de dessus illustrant une variante du procédé décrit en relation avec les figures 4A à 4H ; et
la figure 6 est une vue de côté en coupe représentant de façon très schématique un mode de réalisation d'un via creux de diamètre supérieur à 10 µm.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Les inventeurs ont étudié les phénomènes de dissipation de la chaleur produite dans un via.

Une première partie de la chaleur se propage à partir du haut et du bas du via vers les pistes d'interconnexion de la puce. Toutefois, la surface de dissipation fournie par les pistes d'interconnexion est faible. En outre, des couches isolantes, généralement d'oxyde de silicium, sont intercalées entre les niveaux d'interconnexion successifs. Il en résulte que la dissipation de chaleur par l'intermédiaire des pistes d'interconnexion est faible.

Une deuxième partie de la chaleur est dissipée, à partir de la surface latérale externe du via, à travers la gaine isolante, dans le corps du substrat. Toutefois, la faible conductivité thermique de la gaine isolante limite la dissipation de chaleur dans le corps du substrat.

On cherche ici à améliorer les échanges thermiques entre un via et le corps du substrat qu'il traverse, de façon à réduire l'élévation de la température du via.

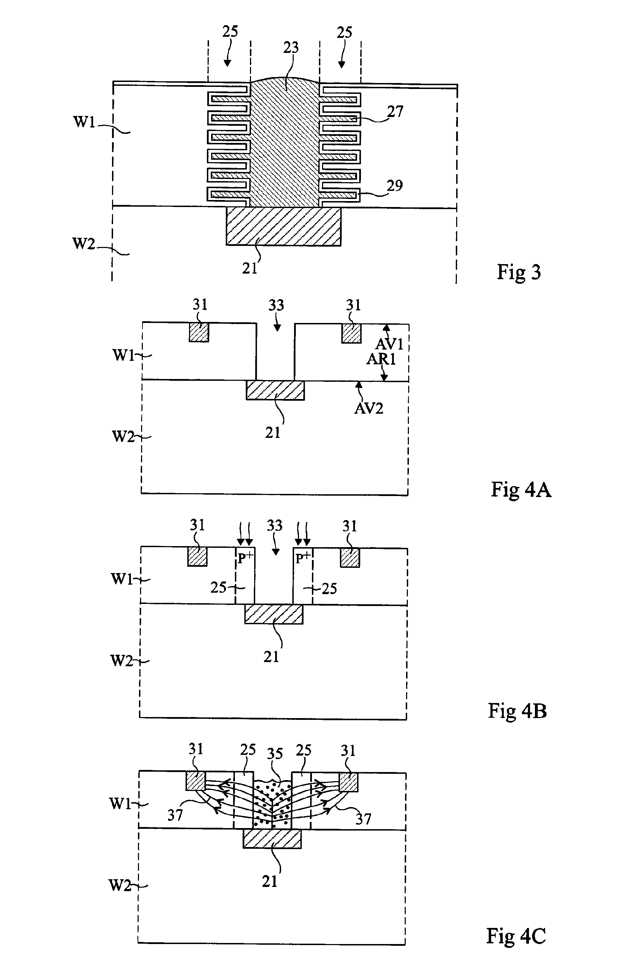

La figure 3 est une vue de côté en coupe illustrant de façon très schématique un exemple d'un mode de réalisation d'un via plein de diamètre inférieur à 10 µm.

Une puce ou tranche semiconductrice amincie W1 est superposée à une puce ou tranche semiconductrice W2 de la façon décrite en relation avec les figures 1A et 1B. Au niveau de la face commune aux puces W1 et W2, il est prévu un plot de contact conducteur 21, correspondant par exemple à une portion de cuivre d'un niveau d'interconnexion supérieur de la puce W2. Le plot de contact 21 est relié à une borne de la puce par des pistes conductrices non représentées de façon à pouvoir être connecté à un potentiel de référence lors d'étapes d'électrolyse décrites ci-après.

Un via plein 23, par exemple un cylindre droit à section circulaire, traverse de part en part la puce W1 et forme un contact électrique avec le plot 21 de la puce W2. Autour du via 23 s'étend une couronne poreuse 25 remplie d'excroissances conductrices 27 solidaires du via 23. Un exemple de procédé de réalisation de la couronne 25 sera décrit ci-après. Une couche isolante 29, constituée par exemple d'oxyde de silicium, isole du substrat le via 23 et les excroissances 27.

La représentation du via 23 donnée en figure 3 est très schématique. En particulier, bien que les excroissances 27 aient été représentées comme s'étendant horizontalement, rectilignement, et identiquement, elles ne sont en pratique pas régulières et s'étendent dans des directions variées autour du via 23. De plus, cette représentation n'est pas à l'échelle. A titre d'exemple, la longueur des excroissances 27 peut être de l'ordre de 5 à 20 % du diamètre de la partie pleine du via 23, par exemple de l'ordre de 0,1 µm pour un via d'un diamètre de l'ordre de 1 µm. Le diamètre des excroissances 27 peut varier de 20 nm à 500 nm en fonction des caractéristiques de la région poreuse 25.

Un avantage du mode de réalisation proposé est que la surface de contact entre le via comportant des excroissances et la couche isolante d'oxyde de silicium est augmentée par rapport au cas des vias classiques à surface latérale lisse. Il en résulte une augmentation des échanges thermiques entre le via et le substrat de la puce. Ceci limite l'élévation de température du via et les risques de dégradation associés.

Les figures 4A à 4H illustrent des étapes successives d'un exemple de procédé de réalisation du via de la figure 3.

Les figures 4A à 4D sont des vues de côté en coupe illustrant la réalisation d'une couronne poreuse à la périphérie d'un trou traversant le substrat.

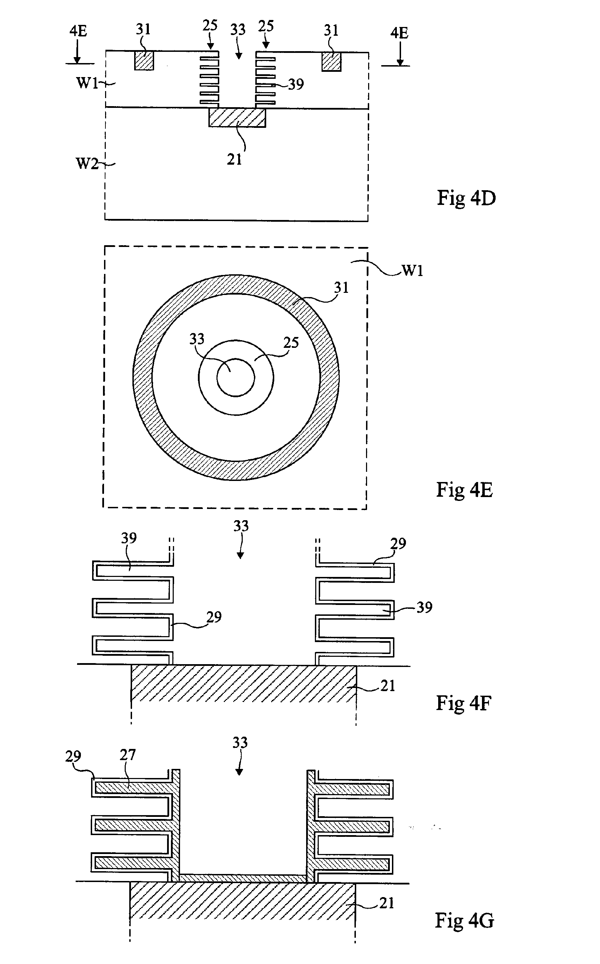

La figure 4E est une vue de dessus en coupe selon le plan 4E-4E de la figure 4D.

Les figures 4F à 4H sont des vues de côté en coupe, agrandies par rapport aux vues des figures 4A à 4D, illustrant des étapes d'isolation et de remplissage de la couronne poreuse et du trou par un matériau conducteur.

La figure 4A représente une puce ou tranche semiconductrice W1 accolée par sa face arrière AR1 à la face avant AV2 d'une puce ou tranche semiconductrice W2, de la façon décrite en relation avec les figures 1A et 1B. La puce W2 comporte, du côté de sa face avant AV2, un plot conducteur 21 en contact avec la face arrière AR1 de la puce W1.

Une électrode 31 est réalisée dans le substrat de la puce W1, du côté de sa face avant AV1. L'électrode 31 a, dans cet exemple, la forme d'une couronne entourant la région dans laquelle doit être formé le via. Le centre de la couronne 31 est à la verticale du plot de contact 21. A titre d'exemple, une tranchée en forme de couronne est creusée dans le substrat puis remplie de cuivre. On pourra en outre prévoir, entre le cuivre et le substrat, une couche mince d'un matériau adapté à empêcher la diffusion du cuivre dans le silicium, par exemple du tantale (Ta) ou de nitrure de titane (TiN).

Un trou 33 traversant de part en part la puce W1 en regard du plot de contact 21 est alors percé. Le centre du trou 33 coïncide sensiblement avec le centre de la couronne 31.

La figure 4B illustre une étape de dopage de la région de substrat 25 que l'on souhaite rendre poreuse. Dans cet exemple, on dope fortement de type P, par exemple par implantation d'atomes de bore, une couronne 25 s'étendant à partir de la périphérie du trou 33. Un masque sélectif non représenté recouvre la surface de la puce W1 pendant l'étape de dopage pour délimiter la région 25. A titre d'exemple, le diamètre externe de la couronne 25 peut être supérieur de 5 à 20 % au diamètre du trou 33.

La figure 4C illustre une étape d'anodisation électrochimique conduisant à la formation de pores dans la couronne dopée 25. Le trou 33 est rempli d'une solution électrolytique 35 à base d'acide fluorhydrique. Dans la pratique, l'assemblage formé par les puces W1 et W2 accolées est entièrement plongé dans un bain d'électrolyse. Une différence de potentiel est appliquée entre le plot de contact 21 et l'électrode 31. Il circule alors un courant selon des lignes 37 passant par la solution électrolytique 35 et par la région dopée 25. Il en résulte la formation de pores dans la région 25.

La figure 4D représente des pores 39 formés dans la région périphérique 25 à l'issue de l'étape d'anodisation électrochimique. La profondeur et le diamètre des pores dépendent notamment de la durée d'anodisation, de l'intensité du courant, et de la composition de la solution électrolytique 35. A nouveau, les pores s'étendent de façon irrégulière à la périphérie du trou 33.

La figure 4E est une vue de dessus en coupe de la figure 4D. La région poreuse 25 formée à l'issue de l'étape d'anodisation électrochimique a la forme d'une couronne s'étendant à partir de la périphérie du trou 33.

Les figures 4F à 4H sont des vues partielles agrandies dans le même plan de coupe que les représentations des figures 4A à 4D.

La figure 4F illustre la formation d'une couche isolante 29 sur les parois du trou 33 et des pores 39. La couche 29 peut être déposée selon un procédé de dépôt conforme fin, par exemple de type ALD (acronyme des termes anglo-saxons "Atomic Layer Deposition"). Tout autre procédé adapté à former un film fin sur des surfaces irrégulières et difficiles d'accès peut être utilisé.

La figure 4G illustre la formation des excroissances conductrices 27 par dépôt conforme fin de cuivre, par exemple de type ALD, dans les pores 39 et sur les parois du trou 33.

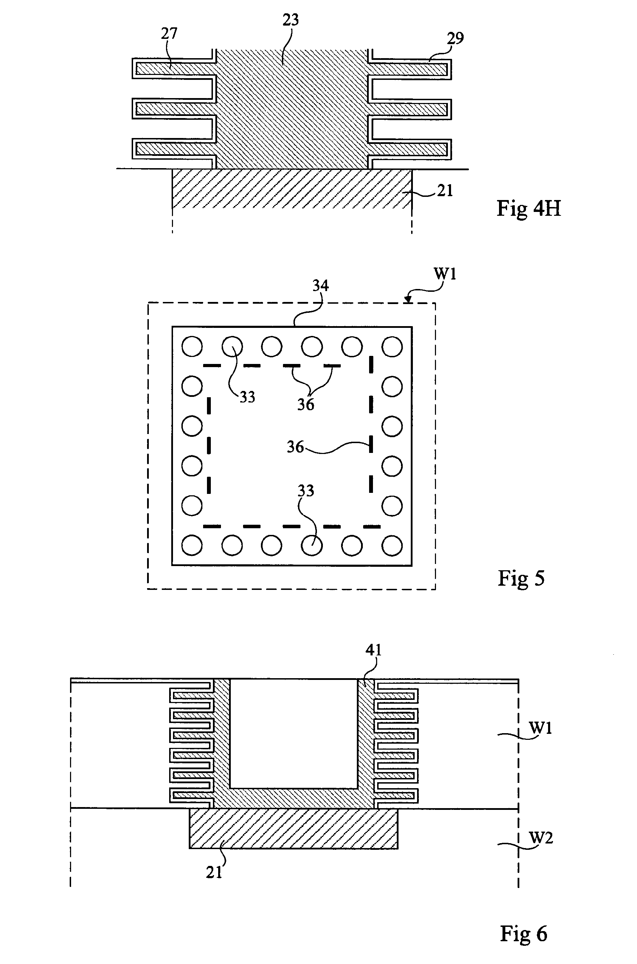

La figure 4H illustre la formation de la partie pleine du via 23, par exemple par dépôt électrolytique du type décrit en relation avec les figures 1A à 1C.

La figure 5 est une vue de dessus en coupe illustrant une variante de mise en oeuvre du procédé décrit ci-dessus. Une puce W1 est traversée de part en part par des trous 33 répartis à sa périphérie selon des rangées parallèles aux côtés de la puce. Une première électrode d'anodisation électrochimique 34 s'étend le long de la périphérie de la puce à l'extérieur des rangées de trous 33. D'autres électrodes 36 sont disposées sur la puce vers l'intérieur par rapport aux trous 33. Les électrodes 34 et 36 correspondent à l'électrode 31 des figures 4D et 4E. Les électrodes 34 et 36 sont toutes reliées à un même potentiel. Le procédé de réalisation des vias est identique à celui décrit en relation avec les figures 4A à 4H.

A l'issue de l'étape d'anodisation électrochimique, les régions poreuses s'étendent, à partir de la périphérie de chaque trou 33, vers les électrodes 34 et 36. Ainsi, les régions poreuses ne constituent pas, autour des trous 33, des couronnes d'épaisseur régulière, mais des couronnes discontinues ou d'épaisseur irrégulière.

On a décrit ici des exemples de réalisation d'un via plein de diamètre inférieur à 10 µm. Toutefois, on pourra également réaliser un via creux de diamètre supérieur à quelques µm, par exemple de l'ordre de 10 à 200 µm, similaire aux vias du type décrit en relation avec les figures 2A à 2C, et comportant sur sa surface latérale extérieure des excroissances s'étendant dans des pores d'une région périphérique de substrat poreux.

La figure 6 est une vue de côté en coupe représentant de façon schématique un tel via creux 41. Le via 41 peut être réalisé selon un procédé similaire à celui décrit en relation avec les figures 4A à 4H, à la différence que la partie principale du via n'est pas formée par dépôt électrolytique, tel que décrit en relation avec la figure 4H, mais par exemple par dépôt conforme, selon le mode de réalisation d'un via creux décrit en relation avec les figures 2A et 2B.

Des modes de réalisation particuliers de la présente invention ont été décrits. Diverses variantes et modifications apparaîtront à l'homme de l'art.

Dans le cas d'un procédé de fabrication d'un via tubulaire, pour augmenter encore la surface d'échange entre le via et le substrat, on pourra prévoir un via ayant, en coupe dans un plan parallèle aux faces avant et arrière du substrat, la forme d'un anneau festonné.

En outre, la présente description mentionne des vias et des pistes d'interconnexion en cuivre. Toutefois, l'invention ne se limite pas à ce seul cas particulier. L'homme de l'art saura également mettre en oeuvre le fonctionnement recherché en utilisant d'autres métaux ou matériaux conducteurs, par exemple du silicium polycristallin fortement dopé, pour former la partie conductrice des vias.

De plus, l'invention ne se limite pas aux procédés de formation de la partie conductrice du via par dépôt électrolytique ou par dépôt conforme, tel que mentionné ci-dessus. A titre d'exemple, la partie conductrice du via pourra être déposée par voie chimique en phase vapeur de silicium polycristallin. Ce silicium sera fortement dopé pour être rendu conducteur.

De même, l'homme de l'art saura mettre en oeuvre le fonctionnement recherché quels que soient les matériaux isolants utilisés pour former les diverses couches isolantes mentionnées dans la description. En particulier, pour améliorer encore les échanges thermiques entre un via et le substrat, la gaine pourra être constituée d'un matériau électriquement isolant mais thermiquement conducteur.

## Revendications

1. Via de connexion électrique (23) plein reliant la
face avant à la face arrière d'un substrat semiconducteur (W1), ce via plein comportant une partie principale traversant de part en part le substrat, ledit substrat comportant une région poreuse (25) s'étendant à
partir d'au moins une partie de la périphérie de la partie principale du via, le via comportant en outre des excroissances conductrices (27) s'étendant dans des pores (39) de la région poreuse, la longueur desdites excroissances conductrices étant comprise entre 5 % et 20 % du diamètre de la partie principale du via, et le diamètre des excroissances conductrices (27) étant compris entre 20 et 500 nm.

2. Via selon la revendication 1, isolé du substrat par une couche mince (29) d'un matériau électriquement isolant.

3. Procédé de fabrication d'un via de connexion électrique (23) reliant la face avant à la face arrière d'un substrat semiconducteur (W1), comportant les étapes successives suivantes :
a) percer un trou (33) traversant le substrat de part en part ;
b) rendre poreuse une région (25) du substrat à la périphérie du trou par anodisation électrochimique ; et
c) remplir les pores (39) de ladite région poreuse (25) d'un matériau électriquement conducteur et recouvrir la paroi du trou (33) dudit matériau électriquement conducteur,
procédé dans lequel un plot de contact (21) est accolé à la face arrière du substrat (W1) en regard du trou (33), et au moins une électrode (31) est formée du côté de la face avant du substrat (W1), à proximité du trou (33), et dans lequel à l'étape b), le plot de contact (21) et ladite au moins une électrode (31) constituent des bornes distinctes d'électrolyse.

4. Procédé selon la revendication 3, dans lequel l'étape b) comporte en outre une étape de dopage de ladite région (25) du substrat à la périphérie du trou (33) avant l'étape d'anodisation électrochimique.

5. Procédé selon la revendication 3 ou 4, dans lequel ladite au moins une électrode (31) a la forme, en vue de dessus, d'une couronne entourant le trou (33).

6. Procédé selon l'une quelconque des revendications 3 à 5, dans lequel l'étape c) comprend une étape de dépôt conforme fin dudit matériau électriquement conducteur.

7. Procédé selon l'une quelconque des revendications 3 à 6, comportant, après l'étape c), une étape de remplissage du trou (33) par dépôt électrolytique d'un matériau conducteur.

8. Procédé selon l'une quelconque des revendications 3 à 6, comportant, après l'étape c), une étape de dépôt conforme d'un matériau conducteur sur les parois du trou (33).

9. Procédé selon l'une quelconque des revendications 3 à 8, comportant en outre, après l'étape b) et avant l'étape c), une étape de dépôt conforme d'une couche isolante (29).

## Claims

1. A solid via (23) connecting the front surface of a semiconductor substrate (W1) to the rear surface thereof, said solid via comprising a main portion traversing the substrate, said substrate comprising a porous region (25) extending from at least a portion of the periphery of the main portion of the via, the via further comprising conductive outgrowths (27) extending in pores (39) of the porous region, the length of said conductive outgrowths ranging between 5% and 20% of the diameter of the main portion of the via, and the diameter of the conductive outgrowths (27) being comprised between 20 and 500 nm.

2. The via of claim 1, insulated from the substrate by a thin layer (29) of an electrically-insulating material.

3. A method for manufacturing a via (23) connecting the front surface of a substrate (W1) to the rear surface thereof, comprising the successive steps of:
a) boring a hole (33) traversing the substrate;
b) making porous a region (25) of the substrate at the periphery of the hole by electrochemical anodization; and
c) filling the pores (39) of said porous region (25) and covering the wall of the hole (33) with an electrically conductive material,
method wherein a contact pad (21) is placed against the rear surface of the substrate (W1) in front of the hole (33), and at least one electrode (31) is formed on the front surface side of the substrate (W1), close to the hole (33), and wherein, at step b), the contact pad (21) and said at least one electrode (31) form separate electrolysis terminals.

4. The method of claim 3, wherein step b) further comprises a step of doping of said substrate region (25) at the periphery of the hole (33) before the electrochemical anodization step.

5. The method of claim 3 or 4, wherein said at least one electrode (31) has the shape, in top view, of a ring surrounding the hole (33).

6. The method of any of claims 3 to 5, wherein step c) comprises a step of thin conformal deposition of the electrically-conductive material.

7. The method of any of claims 3 to 6, comprising, after step c), a step of filling of the hole (33) by electrodeposition of a conductive material.

8. The method of any of claims 3 to 6, comprising, after step c), a step of conformal deposition of a conductive material on the walls of the hole (33).

9. The method of any of claims 3 to 8, further comprising, after step b) and before step c), a step of conformal deposition of an insulating layer (29).

## Patentansprüche

1. Eine feste bzw. solide Durchkontaktierung (Via) (23), die die Vorderoberfläche eines Halbleitersubstrats (W1) mit der Rückoberfläche davon verbindet, wobei die solide Durchkontaktierung einen Hauptteil aufweist, der das Substrat durchquert, wobei das Substrat eine poröse Region oder Zone (25) aufweist, die sich von mindestens einem Teil der Peripherie des Hauptteils der Durchkontaktierung erstreckt,
wobei die Durchkontaktierung ferner leitende Auswüchse (27) aufweist, die sich in Poren (39) der porösen Region erstrecken, wobei die Länge der erwähnten leitenden Auswüchse im Bereich liegt zwischen 5 % und 20 % des Durchmessers des Hauptteils der Durchkontaktierung, und wobei der Durchmesser der leitenden Auswüchse (27) zwischen 20 und 500 nm liegt.

2. Durchkontaktierung nach Anspruch 1, isoliert vom Substrat durch eine dünne Schicht (29) aus elektrisch isolierendem Material.

3. Ein Verfahren zur Herstellung einer Durchkontaktierung (23), die die Vorderoberfläche eines Substrats (W1) mit der hinteren Oberfläche desselben verbindet, wobei die folgenden aufeinanderfolgenden Schritte vorgesehen sind:
a) Bohren eines Lochs (33), welches das Substrat durchdringt (traversiert);
b) Herstellen einer porösen Zone oder Region (25) des Substrats an dem Umfang des Lochs durch elektro-chemische Anodisierung; und
c) Füllen der Poren (39) der porösen Region oder Zone (25) und Abdecken der Wand des Lochs (33) mit einem elektrisch leitenden Material,
wobei das Verfahren weiterhin vorsieht, dass ein Kontaktanschluss (21) an der hinteren Oberfläche des Substrats (W1) vor dem Loch (33) platziert wird, und dass mindestens eine Elektrode (31) an der vorderen Oberflächenseite des Substrats (W1) gebildet wird, und zwar nahe dem Loch (33) und wobei schließlich im Schritt b) die Kontaktfläche (21) und die mindestens eine Elektrode (31) getrennte Elektrolyseanschlüsse bilden.

4. Verfahren nach Anspruch 3, wobei der Schritt b) ferner ein Schritt des Dotierens der erwähnten Substratregion (25) aufweist und zwar am Umfang des Lochs (33) vor dem elektro-chemischen Analysierungsschritt.

5. Verfahren nach Anspruch 3 oder 4, wobei die erwähnte mindestens eine Elektrode (31) in Draufsicht die Form eines das Loch (33) umgebenden Rings besitzt.

6. Verfahren nach einem der Ansprüche 3 bis 5, wobei der Schritt c) einen Schritt der dünnen konformen Abscheidung des elektrisch leitenden Materials aufweist.

7. Verfahren nach einem der Ansprüche 3 bis 6, wobei nach dem Schritt c) ein Schritt des Füllens des Lochs (33) vorgesehen ist und zwar durch Elektroabscheidung eines leitenden Materials.

8. Verfahren nach einem der Ansprüche 3 bis 6, wobei nach dem Schritt c) ein Schritt der konformen Abscheidung eines leitenden Materials auf den Wänden des Lochs (33) vorgesehen ist.

9. Verfahren nach einem der Ansprüche 3 bis 8, wobei ferner nach dem Schritt b) vor dem Schritt c) ein Schritt des konformen Abscheidens einer Isolierschicht (29) vorgesehen ist.
